Europäisches Patentamt

European Patent Office

Office européen des brevets

(11) Veröffentlichungsnummer: **0 212 203**
A2

# (12) EUROPÄISCHE PATENTANMELDUNG

(21) Anmeldenummer: 86109355.7

(22) Anmeldetag: 09.07.86

(51) Int. Cl.⁴ **B65H 75/22** , B65H 75/14

(30) Priorität: 19.07.85 DE 8520877 U

(43) Veröffentlichungstag der Anmeldung:
04.03.87 Patentblatt 87/10

(84) Benannte Vertragsstaaten:
DE FR GB

(71) Anmelder: HOECHST AKTIENGESELLSCHAFT
Postfach 80 03 20
D-6230 Frankfurt am Main 80(DE)

(72) Erfinder: Hilger, Manfred
Langenbergring 74
D-5503 Konz(DE)

(54) Wickelrolle zum Auf- und Abwickeln von Fotoresistmaterial.

(57) Die Wickelrolle umfaßt eine Wickelhülse 2 und zwei Endscheiben 5,5, die auf die Wickelhülse aufgesteckt sind und an die Stirnseiten eines auf die Wickelhülse aufgewickelten Fotoresistwickels 3 angedrückt sind. Die Endscheiben sind mittels Spannfedern 6,6 befestigt, die auf der über die Endscheiben überstehenden Wickelhülse aufsitzen.

FIG.1

EP 0 212 203 A2

## WICKELROLLE ZUM AUF-UND ABWICKELN VON FOTORESISTMATERIAL

Die Erfindung betrifft eine Wickelrolle zum Auf- und Abwickeln von Fotoresistmaterial, mit einer Wickelhülse und zwei Endscheiben.

Es ist bekannt, daß bei Fotoresisten für die Herstellung von Druck-und Leiterplatten, in Abhängigkeit von der Dicke und Zusammensetzung der strahlungshärtbaren Fotopolymerschicht, in Fällen, in denen das Fotoresistmaterial aufgerollt, in Blattform gestapelt oder in anderer Weise der Einwirkung von Druck und/oder der Umgebungstemperatur ausgesetzt ist, die strahlungshärtbare Fotopolymerschicht von den Kanten des Fotoresistmaterials kaltfließt und dadurch die Kanten der Lagen des Fotoresistmaterials miteinander verkleben (DE-AS 23 45 120).

Wird eine Fotoresistrolle, deren aufeinanderfolgenden Wickellagen an den Kanten miteinander verklebt sind, in einen Laminator eingelegt und zu Laminierzwecken abgewickelt, so verhindern die verklebten Kanten das glatte Abwickeln der Fotoresistrolle, wodurch es zu einer Beschädigung des Fotoresists, einer Verschmutzung des Laminators und/oder einer mangelhaften Laminierung der Druck-und/oder Leiterplatten kommt. Um das voranstehend beschriebene Kaltfließen der Fotopolymerschicht bei längerer Lagerung zu verhindern, wird gemäß der DE-AS 23 45 120 vorgeschlagen, die Kanten der strahlungshärtbaren Fotopolymerschicht des Fotoresists durch Belichten mit Ultraviolettlicht zu härten. Die gehärteten Ränder bzw. Kanten schließen den Rest der strahlungshärtbaren Fotopolymerschicht innerhalb der Ränder ein und verhindern ihr Ausfließen. Hierdurch wird erreicht, daß die Fotopolymerschicht unter Einwirkung erhöhten Druckes, beispielsweise beim Aufrollen oder Stapeln des Fotoresistmaterials und/oder durch Lagerung bei erhöhten Temperaturen, nicht mehr seitlich an den Rändern des gestapelten Fotoresistmaterials austreten kann.

Je höher die Wickelspannung einer Fotoresistrolle ist, d.h. der Preßdruck zwischen den einzelnen Wickellagen, desto stärker ist das Kaltfließen der Fotopolymerschicht des Fotoresists und somit der Austritt und das Verkleben an den Stirnrändern des Fotoresistwickels. Üblicherweise werden die Fotoresistmaterialien, die aus einer Trägerschicht, der darauf aufgetragenen strahlungshärtbaren Fotopolymerschicht und einer Deck-bzw. Schutzfolie bestehen, bahnweise auf einer Wickelhülse aufgewickelt, die keine End-bzw. Abschlußscheiben aufweist. Wird die Wickelspannung beim Aufwickeln auf die waagerecht angeordnete Wickelhülse erniedrigt, um das Kaltfließen der Fotopolymerschicht des Fotoresists zu verringern, besteht die Gefahr, daß infolge von Schräg-oder Senkrechtstellung der Fotoresistrolle während des Transports und der Lagerung ein sogenanntes Teleskopieren der einzelnen Wickellagen zueinander auftritt, bei dem die Wickellagen nicht mehr kantendeckungsgleich aufeinanderliegen, sondern die Kanten der einzelnen Wickellagen zueinander versetzt sind.

Aufgabe der Erfindung ist es daher, eine Wickelrolle so zu gestalten, daß eine Fotoresistmaterialbahn mit möglichst geringer Wickelspannung aufgewickelt werden kann, unter Vermeidung des Telekopierens einzelner Wickellagen und des Austritts und Verklebens von Teilen der strahlungshärtbaren Fotopolymerschicht des Fotoresists an den Stirnkanten des Fotoresistwickels während des Transports und der Lagerung der Wickelrolle.

Die Aufgabe wird erfindungsgemäß dadurch gelöst, daß die Endscheiben auf die an den Seiten eines auf die Wickelhülse aufgewickelten Fotoresistmaterials überstehende Wickelhülse aufsteckbar sind und daß die Endscheiben, angedrückt an die Stirnseiten des Fotoresistwickels, auf der Wickelhülse festliegen.

In Ausgestaltung der Erfindung sind die Endscheiben mittels Spannfedern, die an den Außenseiten der Endscheiben anliegen und auf der über die Endscheiben überstehenden Wickelhülse aufsitzen, befestigt.

Die Weiterbildung der Erfindung ergibt sich aus den Merkmalen der übrigen Patentansprüche 3 bis 6.

Mit der Erfindung wird der Vorteil erzielt, daß der Randaustritt und das Teleskopieren der einzelnen Wickellagen der Fotoresistrollen durch starke Reduzierung des Wickeldrucks der Wickellagen des Fotoresistwickels und durch die, auf die jeweilige Bahnbreite der aufgewickelten Fotoresistbahn einstellbaren Endscheiben, verhindert werden.

Die Erfindung wird im folgenden anhand der Zeichnungen näher erläutert. Es zeigen:

Figur 1 einen Schnitt durch eine Wickelrolle mit Spannfedern zum Befestigen der Endscheiben,

Figur 2 einen Schnitt durch eine andere Wickelrolle, bei der die Endscheiben mit der Wickelhülse verklebt sind, und

Figur 3 schematisch das doppelseitige Laminieren einer Platte mit Fotoresist, der von zwei Wickelrollen nach der Erfindung abgewickelt wird.

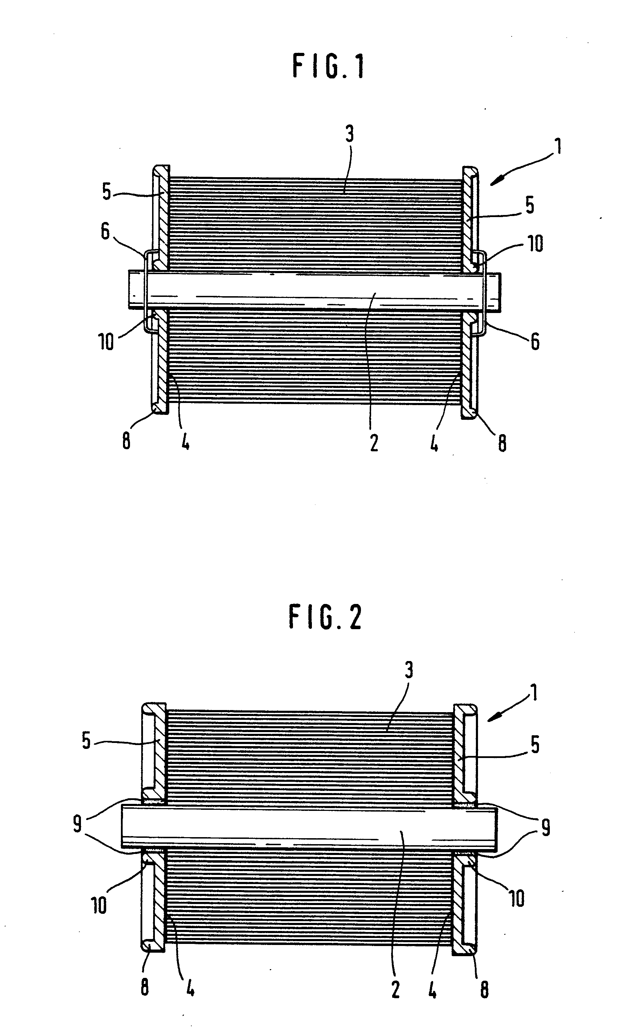

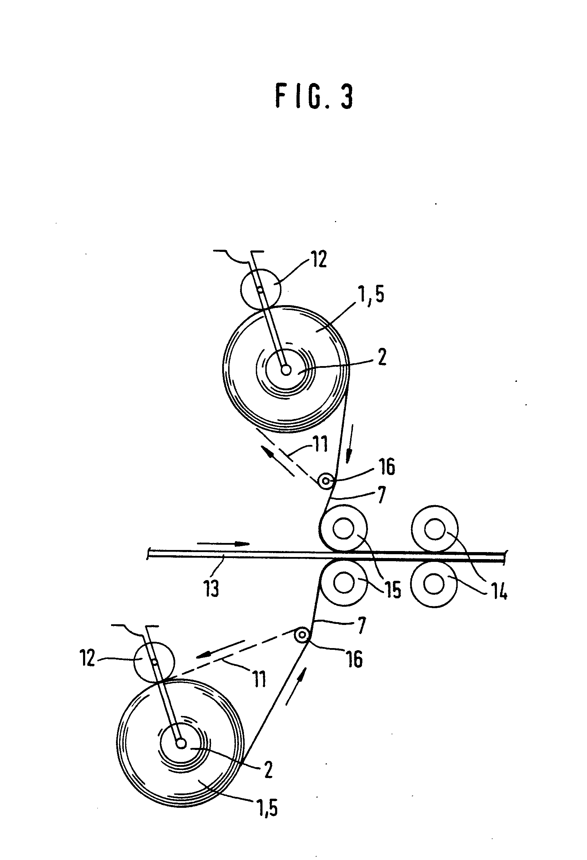

Die in Figur 1 gezeigte Wickelrolle 1 besteht aus einer Wickelhülse 2 und zwei End-bzw. Stirnabschlußscheiben 5,5, die auf die Wickelhülse 2 aufgeschoben und befestigt werden, nachdem das Fotoresistmaterial 7 (siehe Figur 3) als Fotoresistwickel 3 auf der Wickelhülse 2 aufgewickelt ist. Die Endscheiben 5,5 sind auf die an den Seiten des auf die Wickelhülse 2 aufgewickelten Fotoresistmaterials überstehende Wickelhülse 2 aufsteckbar. Das Fotoresistmaterial wird mit geringer Wickelspannung, die etwa nur ein Sechstel der üblichen Wickelspannung für Fotoresistrollen beträgt, auf die Wickelhülse 2 aufgewickelt. Nach dem Schneiden der Fotoresistrollen am Rollenschneider werden die aufgesteckten Endscheiben 5,5 an die Rollenstirnseiten angedrückt. Die Größe der Endscheiben 5,5 ist so gewählt, daß ihr Durchmesser gleich dem Wickeldurchmesser oder bis zu 2 cm größer als der Durchmesser des Fotoresistwickels 3 ist. Die Endscheiben 5,5 sind aus Metall oder Kunststoff gearbeitet und besitzen glatte Innenseitenflächen 4,4, die ein spaltfreies Anliegen der angedrückten Endscheiben an die Stirnseiten des Fotoresistwickels 3 ermöglichen. An den Außenseiten der Endscheiben 5,5 liegen Spannfedern 6,6 an, die auf der über die Endscheiben überstehenden Wickelhülse 2 aufsitzen. Diese Spannfedern 6,6 können auch mit den Endscheiben 5,5 integriert sein und halten die Endscheiben in ihren Positionen fest. Durch die geringe Wickelspannung wird der Wickeldruck der einzelnen Wickellagen untereinander stark vermindert. Die festliegenden Endscheiben 5,5 verhindern das Teleskopieren der einzelnen Wickellagen des Fotoresistmaterials und ermöglichen das Aufwickeln des Fotoresistmaterials mit sehr geringer Wickelspannung, wodurch wiederum das Austreten von Fotoresistmaterial an den Stirnkanten des Wickels verhindert wird.

Bei der in Figur 1 gezeigten Ausführungsform der Endscheiben 5,5 besitzt jede einen umlaufenden Außenwulst 8, der die Biegesteifigkeit der Endscheiben 5,5 erhöht. Desweiteren weist jede der Endscheiben 5,5 einen umlaufenden Innenwulst 10 auf, der unmittelbar auf der Wickelhülse 2 aufsitzt und diese umschließt.

Die in Figur 2 gezeigte Ausführungsform ist weitgehend identisch wie die Ausführungsform nach Figur 1 aufgebaut, mit dem einzigen Unterschied, daß anstelle von Spannfedern zum Befestigen der Endscheiben 5,5 diese mit Hilfe von Klebemassen 9,9, bei denen es sich z.B. um Zweikomponentenkleber handelt, mit der Wickelhülse 2 verklebt werden.

Die Endscheiben 5,5 können auch, obgleich dies nicht dargestellt ist, mittels Widerhaken auf der Wickelhülse 2 befestigt werden.

Die Wickelrolle 1 nach der Erfindung unterscheidet sich von einer bekannten Kunststoffwickelspule zum Auf-und Abwickeln von Drähten, wie sie in dem deutschen Gebrauchsmuster 84 29592 beschrieben ist und bei der Flanschscheiben durch Klebeverbindungen an der Wickelhülse befestigt sind, dadurch, daß die Wickelhülse zugleich auch die Trägerwelle ist, während bei der bekannten Wickelspule die Trägerwelle noch koaxial von der Wickelhülse umgeben ist, auf die dann die Drähte, Kabel oder dergleichen aufgewickelt werden. Da bei der Erfindung die Trägerwelle zugleich die Wickelhülse ist, wird der Vorteil erzielt, daß die Bahnbreite des aufzuwickelnden Fotoresistmaterials frei wählbar ist, da keine die Bahnbreite begrenzenden Endscheiben ortsfest auf der Wickelhülse angebracht sind. Erst bei der Konfektionierung der Rolle werden dann die Endscheiben auf die Wickelhülse aufgeschoben und befestigt.

Beim Einsatz der Wickelrolle 1 in einem Laminator werden die Endscheiben 5,5 nicht entfernt und dienen während des Abwickelns des Fotoresistmaterials 7, wie dies im folgenden anhand Figur 3 erläutert wird, als Auflage beim Aufrollen der Schutzfolie des Fotoresistmaterials 7.

Wie Figur 3 zeigt, ist die Wickelrolle 1 mit den Endscheiben 5 in den Laminator eingesetzt. Das auf der Wickelhülse 2 aufgewickelte Fotoresistmaterial 7 ist mit einer Schutzfolie 11 ausgestattet, die nach dem Durchlaufen eines Duos von Trennwalzen 16 von der strahlungshärtbaren Fotopolymerschicht des Fotoresistmaterials 7 abgezogen und auf eine Schutzfolien-Aufwickelrolle 12 aufgewickelt wird, die auf den Rändern der Endscheiben 5,5 aufliegt. Die Trägerschicht mit der strahlungshärtbaren Fotopolymerschicht des Fotoresistmaterials 7 wird nach den Trennwalzen 16 in Richtung einer horizontal dem Laminator zugeführten Leiterplatte 13 umgelenkt und über eine obere Heizwalze 15 eines Heizwalzenpaares herumgeführt und in Kontakt mit der Oberseite der Leiterplatte 13 gebracht. Der oberen Heizwalze 15 liegt eine untere Heizwalze 15 gegenüber, die nahe der Unterseite der Leiterplatte 13 angeordnet ist. Über die untere Heizwalze 15 wird ebenfalls Fotoresistmaterial 7 geführt und umgelenkt, das auf einer unteren Wickelrolle 1 aufgewickelt ist, und auf die Unterseite der Leiterplatte 13 auflaminiert. In Transportrichtung der Leiterplatte 13 befindet sich nach dem Heizwalzenpaar ein Druckwalzenpaar aus einer oberen und einer unteren Druckwalze 14. Die obere Druckwalze 14 laminiert die strahlungshärtbare Fotopolymerschicht des Fotoresistmaterials 7 auf die Oberseite der Leiterplatte 13 auf, während die untere Druckwalze 14 das Fotoresistmaterial 7 der unteren Wickelrolle 1 auf die Unterseite der Leiterplatte 13 auflaminiert. Wie praktische Versuche gezeigt haben, bestehen keinerlei Probleme bei dem Auflaminieren der Fotoresistmaterialien 7 auf die Leiterplatte 13, obwohl die Wickelspannungen der Fotoresistmaterialien beim Aufwickeln auf die Wickelrollen 1,1 auf ein Sechstel der üblichen Wickelspannungen für Fotoresistrollen verringert waren.

Vorteilhafte Wirkungen bestehen darin, daß durch die fixierten Endscheiben die Resist-Fertigrolle vor äußeren Einflüssen besser geschützt wird und daß Bedienungspersonen keine Hautberührung mit freien Reiststellen bekommen.

**Ansprüche**

1. Wickelrolle zum Auf-und Abwickeln von Fotoresistmaterial, mit einer Wickelhülse und zwei Endscheiben, dadurch gekennzeichnet, daß die Endscheiben (5,5) auf die an den Seiten eines auf die Wickelhülse (2) aufgewickelten Fotoresistmaterials (7) überstehende Wickelhülse (2) aufsteckbar sind und daß die Endscheiben (5,5) angedrückt an die Stirnseiten des Fotoresistwickels (3), auf der Wickelhülse (2) festliegen.

2. Wickelrolle nach Anspruch 1, dadurch gekennzeichnet, daß die Endscheiben (5,5) mittels Spannfedern (6,6), die an den Außenseiten der Endscheiben anliegen und auf der über die Endscheiben überstehenden Wickelhülse (2) aufsitzen, befestigt sind.

3. Wickelrolle nach Anspruch 1, dadurch gekennzeichnet, daß die Größe der Endscheiben - (5,5) so gewählt ist, daß der Durchmesser der Endscheiben gleich dem Wickeldurchmesser oder bis zu 2 cm größer als der Durchmesser des Fotoresistwickels (3) ist.

4. Wickelrolle nach Anspruch 1, dadurch gekennzeichnet, daß die Endscheiben (5,5) mit der Wickelhülse (2) verklebt sind.

5. Wickelrolle nach Anspruch 1, dadurch gekennzeichnet, daß die Endscheiben (5,5) mittels Widerhaken auf der Wickelhülse (2) befestigt sind.

6. Wickelrolle nach Anspruch 1, dadurch gekennzeichnet, daß die Endscheiben (5,5) aus Metall oder Kunststoff bestehen und glatte Innenseitenflächen (4,4) aufweisen, die ein spaltfreies Anliegen der angedrückten Endscheiben an die Stirnseiten des Fotoresistwickels (3) zulassen.

# FIG.1

# FIG.2

# FIG. 3